# EUROPEAN PATENT APPLICATION

(11) **EP 2 530 175 A1**
(43) Date of publication of application: **05.12.2012**
(21) Application number: 11736829.0
(22) Date of filing: 06.01.2011
(51) Int. Cl.: C22C 9/00, C22C 9/01, C22C 9/02, C22C 9/04, C22C 9/05, C22F 1/08, H01B 1/02, C22F 1/00, C22F 1/02

(54) **COPPER ALLOY WITH HIGH STRENGTH AND HIGH ELECTRICAL CONDUCTIVITY**

(30) Priority: 26.01.2010 JP 2010014399; 26.01.2010 JP 2010014398
(71) Applicant: Mitsubishi Materials Corporation, Chiyoda-ku Tokyo 100-8117 (JP)
(72) Inventor: MAKI Kazunari, Kitamoto-shi Saitama 364-0022 (JP); ITO Yuki, Kitamoto-shi Saitama 364-0022 (JP)
(74) Representative: HOFFMANN EITLE
(86) International application number: PCT/JP2011/050103
(87) International publication number: WO 2011/093114

(57) **Abstract**

This copper alloy with high strength and high electrical conductivity includes: Mg: more than 1.0% by mass to less than 4% by mass; and Sn: more than 0.1 % by mass to less than 5% by mass, with a remainder including Cu and inevitable impurities, wherein a mass ratio Mg/Sn of a content of Mg to a content of Sn is in a range of 0.4 or more. This copper alloy with high strength and high electrical conductivity may further include Ni: more than 0.1 % by mass to less than 7% by mass.

## Description

### TECHNICAL FIELD

The present invention relates to a copper alloy with high strength and high electrical conductivity which is suitable for electronic and electrical parts such as connectors, lead frames, and the like.
The present application claims priority on Japanese Patent Application No. 2010-014398 filed on January 26, 2010, and Japanese Patent Application No. 2010-014399 filed on January 26, 2010, the contents of which are incorporated herein by reference.

### BACKGROUND ART

Conventionally, in accordance with a decrease in the sizes of electronic devices, electrical devices, and the like, efforts have been made to decrease the sizes and the thicknesses of electronic and electrical parts such as connector terminals, lead frames, and the like that are used in the electronic devices, electrical devices, and the like. Therefore, there is a demand for a copper alloy that is excellent in spring properties, strength and electrical conductivity as a material that constitutes the electronic and electrical parts.
As a result, as a copper alloy that is excellent in spring properties, strength and electrical conductivity, a Cu-Be alloy containing Be is provided in, for example, Patent Document 1. This Cu-Be alloy is a precipitation-hardened alloy with high strength, and the strength is improved by age-precipitating CuBe in a matrix phase of Cu without degrading the electrical conductivity.

However, the Cu-Be alloy contains an expensive element of Be; and therefore, the cost of raw materials is extremely high. In addition, when the Cu-Be alloy is manufactured, toxic beryllium oxides are generated. As a result, in the manufacturing process, it is necessary to provide a special configuration of manufacturing facilities and strictly manage the beryllium oxides in order to prevent the beryllium oxides from being accidentally leaked outside.
As described above, the Cu-Be alloy had problems in that the cost of raw materials and the manufacturing cost were both high, and the Cu-Be alloy was extremely expensive. In addition, as described above, since a detrimental element of Be was included, the use of the Cu-Be alloy was avoided in terms of environmental protection.
As a result, there has been a strong demand for a material that can replace the Cu-Be alloy.

For example, Non-Patent Document 1 proposes a Cu-Sn-Mg alloy as a copper alloy that replaces the Cu-Be alloy. This Cu-Sn-Mg alloy is produced by adding Mg to a Cu-Sn alloy (bronze), and the Cu-Sn-Mg alloy is an alloy that is excellent in strength and spring properties.

However, the Cu-Sn-Mg alloy described in Non-Patent Document 1 had a problem in that cracking was liable to occur during working. Since the Cu-Sn-Mg alloy described in Non-Patent Document 1 contains a relatively large amount of Sn, intermetallic compounds having a low melting point are unevenly generated in an ingot due to segregation of Sn. When such intermetallic compounds having a low melting point are generated, the intermetallic compounds having a low melting point remain during a subsequent thermal treatment. As a result, cracking becomes liable to occur during subsequent working.
In addition, Sn is cheaper than Be; however, Sn is still a relatively expensive element. Therefore, the cost of raw materials is increased as well.

### PRIOR ART DOCUMENT

### Patent Document

Patent Document 1: Japanese Unexamined Patent Application, First Publication No. 04-268033

### Non-Patent Document

Non-Patent Document 1: P. A. Ainsworth, C. J. Thwaites, R. Duckett, "Properties and manufacturing characteristics of precipitation-hardening tin-magnesium bronze," Metals Technology, August (1974), p. 385 to 390

### DISCLOSURE OF THE INVENTION

### Problems to be Solved by the Invention

The present invention has been made in consideration of the above-described circumstances, and the present invention aims to provide a copper alloy with high strength and high electrical conductivity, the copper alloy does not contain Be; and thereby, the cost of raw materials and the manufacturing cost are low, and the copper alloy is excellent in tensile strength and electrical conductivity, and is also excellent in workability.

### Means for Solving the Problems

A copper alloy with high strength and high electrical conductivity according to a first aspect of the present invention includes: Mg: more than 1.0% by mass to less than 4% by mass; and Sn: more than 0.1 % by mass to less than 5% by mass with a remainder including Cu and inevitable impurities, wherein a mass ratio Mg/Sn of a content of Mg to a content of Sn is in a range of 0.4 or more.

The copper alloy with high strength and high electrical conductivity according to the first aspect is a copper alloy that contains Mg and Sn with a remainder substantially being Cu and inevitable impurities, and the content of Mg, the content of Sn, and the range of the mass ratio Mg/Sn of the content of Mg to the content of Sn are specified. The copper alloy having such a component composition is excellent in tensile strength, electrical conductivity, and workability as described below.

That is, each of Mg and Sn is an element to improve the strength of copper and increase the recrystallization temperature. However, in the case where large amounts of Mg and Sn are included, the workability deteriorates due to intermetallic compounds including Mg or Sn. Therefore, the content of Mg is set to be in a range of more than 1.0% by mass to less than 4% by mass, and the content of Sn is set to be in a range of more than 0.1% by mass to less than 5% by mass. Thereby, it is possible to improve the strength and secure the workability.
Furthermore, when both of Mg and Sn are included, precipitates of (Cu, Sn)₂Mg or Cu₄MgSn which are compounds of theses elements are distributed in the matrix phase of copper. Thereby, it is possible to improve the strength through precipitation hardening. Here, when the mass ratio Mg/Sn is set to be in a range of 0.4 or more, the content of Sn does not become larger than necessary compared to the content of Mg, and it is possible to prevent intermetallic compounds having a low melting point from remaining; and thereby, the workability can be secured.

In the copper alloy with high strength and high electrical conductivity according to the first aspect, the mass ratio Mg/Sn of the content of Mg to the content of Sn may be in a range of 0.8 to 10.
It is possible to reliably obtain the above-described effect of improving the strength due to the including of both of Mg and Sn. In addition, the content of Sn is suppressed; and thereby, the workability can be secured.

The copper alloy with high strength and high electrical conductivity according to the first aspect may further contain at least one or more selected from Fe, Co, Al, Ag, Mn, and Zn, and a content thereof may be in a range of 0.01% by mass or more to 5% by mass or less.
Fe, Co, Al, Ag, Mn, and Zn have an effect of improving the characteristics of the copper alloy, and it is possible to improve the characteristics by selectively including Fe, Co, Al, Ag, Mn, or Zn depending on use.

The copper alloy with high strength and high electrical conductivity according to the first aspect may further contain B: 0.001% by mass or more to 0.5% by mass or less.
B is an element that improves strength and heat resistance. However, in the case where a large amount of B is included, electrical conductivity deteriorates. Therefore, the content of B is set to be in a range of 0.001% by mass or more to 0.5% by mass or less; and thereby, it is possible to improve the strength and the heat resistance while suppressing degradation of the electrical conductivity.

The copper alloy with high strength and high electrical conductivity according to the first aspect may further contain P: less than 0.004% by mass.
P has an effect of lowering the viscosity of a molten copper during melting and casting. Therefore, P is frequently added to a copper alloy in order to ease casting operations. However, P reacts with Mg; and thereby, the effect of Mg is reduced. In addition, P is an element that greatly degrades the electrical conductivity. Therefore, when the content of P is set to be in a range of less than 0.004% by mass, the above-described effect of Mg is reliably obtained; and thereby, the strength can be improved. In addition, degradation of the electrical conductivity can be suppressed.

With regard to the copper alloy with high strength and high electrical conductivity according to the first aspect, a tensile strength may be in a range of 750 MPa or more, and an electrical conductivity may be in a range of 10% IACS or more.
In this case, since the strength and the electrical conductivity are excellent, it is possible to provide a copper alloy with high strength and high electrical conductivity which is suitable for electronic and electrical parts. For example, when the copper alloy with high strength and high electrical conductivity is applied to connector terminals, lead frames, or the like, it is possible to decrease the thickness of the connector terminals, the lead frames, or the like.

A copper alloy with high strength and high electrical conductivity according to a second aspect of the present invention contains Mg: more than 1.0% by mass to less than 4% by mass, Sn: more than 0.1 % by mass to less than 5% by mass, and Ni: more than 0.1 % by mass to less than 7% by mass with a remainder including Cu and inevitable impurities, wherein a mass ratio Mg/Sn of a content of Mg to a content of Sn is in range of 0.4 or more.
The copper alloy with high strength and high electrical conductivity according to the second aspect is the copper alloy with high strength and high electrical conductivity according to the first aspect which further contains Ni at a content of more than 0.1 % by mass to less than 7% by mass.

The copper alloy with high strength and high electrical conductivity according to the second aspect is a copper alloy that contains Mg, Sn, and Ni with a remainder substantially being Cu and inevitable impurities, and the content of Mg, the content of Sn, the content ofNi, and the range of the mass ratio Mg/Sn of the content of Mg to the content of Sn are specified. The copper alloy having such a component composition is excellent in tensile strength, electrical conductivity, and workability as described below.

That is, each of Mg and Sn is an element to improve the strength of copper and increase the recrystallization temperature. However, in the case where large amounts of Mg and Sn are included, the workability deteriorates due to intermetallic compounds including Mg or Sn. Therefore, the content of Mg is set to be in a range of more than 1.0% by mass to less than 4% by mass, and the content of Sn is set to be in a range of more than 0.1% by mass to less than 5% by mass. Thereby, it is possible to improve the strength and secure the workability.

In detail, when both of Mg and Sn are added, precipitates of (Cu, Sn)₂Mg or Cu₄MgSn are distributed in the matrix phase of copper. The strength and the recrystallization temperature are improved through precipitation hardening due to the precipitates.
However, in the case where large amounts of Mg and Sn are included, intermetallic compounds containing Mg or Sn are unevenly generated in an ingot due to segregation of Mg and Sn. Particularly, intermetallic compounds including a large amount of Sn have a low melting point; and therefore, there is a concern that the intermetallic compounds are melted in a subsequent thermal treatment process. In the case where the intermetallic compounds including a large amount of Sn are melted, the intermetallic compounds become liable to remain in the subsequent thermal treatment. The workability is deteriorated due to the remaining of such intermetallic compounds. Therefore, the content of Mg is set to be in a range of more than 1.0% by mass to less than 4% by mass, and the content of Sn is set to be in a range of more than 0.1% by mass to less than 5% by mass.

Furthermore, when the mass Mg/Sn of the content of Mg to the content of Sn is set to be in a range of 0.4 or more, the content of Sn does not become larger than necessary compared to the content of Mg, and it is possible to prevent the generation of intermetallic compounds having a low melting point. Thereby, it is possible to reliably obtain the above-described effect of improving the strength due to the including of both of Mg and Sn. In addition, the workability can be secured.

When Ni is included together with Mg and Sn, Ni has an effect of further improving the strength and the recrystallization temperature. It is assumed that this effect results from precipitates in which Ni is solid-solubilized in (Cu, Sn)₂Mg or Cu₄MgSn. In addition, Ni has an effect of increasing the melting point of intermetallic compounds which are generated in an ingot. Therefore, the intermetallic compounds are suppressed from being melted in a subsequent thermal treatment process; and thereby, it is possible to suppress degradation of the workability which is caused by the remaining of the intermetallic compounds. Meanwhile, in the case where a large amount of Ni is included, the electrical conductivity is degraded.
From the above-described circumstances, the content of Ni is set to be in a range of more than 0.1 % by mass to less than 7% by mass. Thereby, it is possible to improve the strength, improve the workability, and secure the electrical conductivity.

In the copper alloy with high strength and high electrical conductivity according to the second aspect, a mass ratio Ni/Sn of a content ofNi to a content of Sn may be in a range of 0.2 to 3.
Since the mass ratio Ni/Sn of the content of Ni to the content of Sn is set to be in a range of 0.2 or more, the content of Sn decreases. Therefore, generation of the intermetallic compounds having a low melting point can be suppressed; and thereby, the workability can be secured. Furthermore, since the mass ratio Ni/Sn of the content ofNi to the content of Sn is set to be in a range of 3 or less, an excessive amount of Ni is not present; and thereby, degradation of the electrical conductivity can be prevented.

The copper alloy with high strength and high electrical conductivity according to the second aspect may further contain either one or both of P and B, and a content thereof may be in a range of 0.001 % by mass or more to 0.5% by mass or less.
P and B are elements that improve strength and heat resistance. In addition, P has an effect of lowering the viscosity of molten copper during melting and casting. However, in the case where large amounts of P and B are included, the electrical conductivity is degraded. Therefore, when the contents of P and B are set to be in a range of 0.001 % by mass to 0.5% by mass, the strength and the heat resistance can be improved while suppressing degradation of the electrical conductivity.

The copper alloy with high strength and high electrical conductivity according to the second aspect may further contain at least one or more selected from Fe, Co, Al, Ag, Mn, and Zn, and a content thereof may be in a range of 0.01 % by mass or more to 5% by mass or less.
Fe, Co, Al, Ag, Mn, and Zn have an effect of improving the characteristics of the copper alloy, and it is possible to improve the characteristics by selectively including one or more of Fe, Co, Al, Ag, Mn, and Zn depending on use.

With regard to the copper alloy with high strength and high electrical conductivity according to the second aspect, a tensile strength may be in a range of 750 MPa or more, and an electrical conductivity may be in a range of 10% IACS or more.
In this case, since the strength and the electrical conductivity are excellent, it is possible to provide a copper alloy with high strength and high electrical conductivity which is suitable for electronic and electrical parts. For example, when the copper alloy with high strength and high electrical conductivity is applied to connector terminals, lead frames, or the like, it is possible to decrease the thickness of the connector terminals, the lead frames, or the like.

### Effects of the Invention

According to the first and second aspects of the invention, it is possible to provide a copper alloy with high strength and high electrical conductivity, and the copper alloy does not contain Be; and therefore, the raw material cost and the manufacturing cost are low. In addition, the copper alloy is excellent in tensile strength and electrical conductivity, and is also excellent in workability.

### BEST MODE FOR CARRYING OUT THE INVENTION

Hereinafter, a copper alloy with high strength and high electrical conductivity according to an embodiment of the present invention will be described.

### (First embodiment)

A copper alloy with high strength and high electrical conductivity according to a first embodiment has a composition which includes: Mg: more than 1.0% by mass to less than 4% by mass; Sn: more than 0.1 % by mass to less than 5% by mass; at least one or more selected from Fe, Co, Al, Ag, Mn, and Zn: 0.01 % by mass or more to 5% by mass or less; B: 0.001 % by mass or more to 0.5% by mass or less; and P: less than 0.004% by mass with a remainder being Cu and inevitable impurities.
In addition, the mass ratio Mg/Sn of the content of Mg to the content of Sn is in a range of 0.4 or more.
In the copper alloy with high strength and high electrical conductivity according to the first embodiment, the tensile strength is in a range of 750 MPa or more, and the electrical conductivity is in a range of 10% IACS or more.

Hereinafter, reasons why the contents of the above elements are limited in the above ranges will be described.

### (Mg)

Mg is an element having an effect of improving the strength without greatly degrading the electrical conductivity. In addition, Mg has an effect of increasing the recrystallization temperature. Here, in the case where the content of Mg is in a range of 1.0% by mass or less, the above-described effects cannot be obtained.
On the other hand, in the case where the content of Mg is in a range of 4.0% by mass or more, intermetallic compounds including Mg remain when a thermal treatment is carried out for homogenization and solution treatment. Thereby, sufficient homogenization and solution treatment cannot be carried out. As a result, there is a concern that cracking may occur in cold working or hot working after the thermal treatment.
From such reasons, the content of Mg is set to be in a range of more than 1.0% by mass to less than 4% by mass.
Furthermore, Mg is a reactive metal. Therefore, in the case where an excessive amount of Mg is added, there is a concern that Mg oxides generated by reactions with oxygen may be included during melting and casting. In order to suppress the including of the Mg oxides, the content of Mg is preferably set to be in a range of more than 1.0% by mass to less than 3 % by mass.

### (Sn)

Sn is an element of being solid-solubilized in a matrix phase of copper; and thereby, Sn has an effect of improving the strength and increasing the recrystallization temperature. Here, in the case where the content of Sn is in a range of 0.1% by mass or less, the effects cannot be obtained.
On the other hand, in the case where the content of Sn is in a range of 5% by mass or more, the electrical conductivity is greatly decreased. In addition, intermetallic compounds containing Sn and having a low melting point are unevenly generated due to segregation of Sn. Therefore, the intermetallic compounds containing Sn and having a low melting point remain when a thermal treatment is carried out for homogenization and solution treatment. Thereby, sufficient homogenization and solution treatment cannot be carried out. As a result, there is a concern that cracking may occur in cold working or hot working after the thermal treatment. In addition, Sn is a relatively expensive element. Therefore, in the case in where Sn is added at a content of more than necessary, the manufacturing cost increase.
From such reasons, the content of Sn is set to be in range of more than 0.1 % by mass to less than 5% by mass. Meanwhile, in order to reliably obtain the above-described effects, the content of Sn is preferably set to be in a range of more than 0.1% by mass to less than 2% by mass.

### (Mg/Sn)

In the case where both of Mg and Sn are included, precipitates of (Cu, Sn)₂Mg or Cu₄MgSn, which are compounds thereof, are distributed in the matrix phase of copper; and thereby, the strength can be improved due to precipitation hardening.
Here, in the case where the mass ratio Mg/Sn of the content of Mg to the content of Sn is in a range of less than 0.4, a large amount of Sn is included compared to the content of Mg. In this case, as described above, the intermetallic compounds having a low melting point become liable to be generated; and thereby, the workability is degraded.
From such reasons, the mass ratio Mg/Sn of the content of Mg to the content of Sn is set to be in a range of 0.4 or more; and thereby, the workability is secured.
Meanwhile, in order to suppress the remaining of the intermetallic compounds containing Sn and having a low melting point so as to reliably secure the workability and to reliably obtain the effect of improving the strength due to Sn, the mass ratio Mg/Sn of the content of Mg to the content of Sn is preferably set to be in a range of 0.8 to 10.

### (Fe, Co, Al, Ag, Mn, and Zn)

Fe, Co, Al, Ag, Mn, and Zn have an effect of improving the characteristics of a copper alloy, and it is possible to improve the characteristics by selectively including one or more of Fe, Co, Al, Ag, Mn, and Zn in accordance with use. Here, in the case where the content of at least one or more of elements selected from Fe, Co, Al, Ag, Mn, and Zn is in a range of less than 0.01 % by mass, the effects cannot be obtained.
On the other hand, in the case where the content of at least one or more of elements selected from Fe, Co, Al, Ag, Mn, and Zn exceeds 5% by mass, the electrical conductivity is greatly degraded.
From such reasons, the content of at least one or more of elements selected from Fe, Co, Al, Ag, Mn, and Zn is set to be in a range of 0.01 % by mass to 5% by mass.

### (B)

B is an element that improves the strength and the heat resistance. Here, in the case where the content of B is in a range of less than 0.001% by mass, the effects cannot be obtained.
On the other hand, in the case where the content of B exceeds 0.5% by mass, the electrical conductivity is greatly degraded.
From such reasons, the content of B is set to be in a range of 0.00 1 % by mass or more to 0.5% by mass or less.

### (P)

P has an effect of lowering the viscosity of molten copper during melting and casting. Therefore, P is frequently added to a copper alloy in order to ease casting operations. However, since P reacts with Mg, P reduces the effect of Mg. In addition, P is an element that greatly degrades the electrical conductivity.
Therefore, in order to reliably obtain the effects of Mg and to suppress degradation of the electrical conductivity, the content of P is set to be in a range of less than 0.004% by mass.

Meanwhile, the inevitable impurities include Ca, Sr, Ba, Sc, Y, rare earth elements, Zr, Hf, V, Nb, Ta, Cr, Mo, W, Re, Ru, Os, Se, Te, Rh, Ir, Pd, Pt, Au, Cd, Ga, In, Li, Si, Ge, As, Sb, Ti, Tl, Pb, Bi, S, O, C, Be, N, H, Hg, and the like. The inevitable impurities are preferably included at a total content of 0.3% by mass or less.

With regard to the copper alloy with high strength and high electrical conductivity according to the first embodiment having the above-described chemical components, Mg and Sn are included, the content of Mg is set to be in a range of more than 1.0% by mass to less than 4% by mass, the content of Sn is set to be in a range of more than 0.1 % by mass to less than 5% by mass, and the mass ratio Mg/Sn of the content of Mg to the content of Sn is set to be in a range of 0.4 or more. Therefore, by including both of Mg and Sn, it is possible to improve the strength due to solid solution hardening and precipitation hardening. In addition, and the contents of Mg and Sn are suppressed; and thereby, the workability can be secured.

In addition, at least one or more selected from Fe, Co, Al, Ag, Mn, and Zn are included, and the content thereof is set to be in a range of 0.01 % by mass or more to 5% by mass or less. Therefore, due to one or more elements selected from Fe, Co, Al, Ag, Mn, and Zn, it is possible to improve the characteristics of the copper alloy without greatly degrading the electrical conductivity.
Furthermore, B is included, and the content thereof is set to be in a range of 0.001 % by mass or more to 0.5% by mass or less. Therefore, it is possible to improve the strength and the heat resistance while suppressing degradation of the electrical conductivity.
In addition, since the content of P is set to be in a range of less than 0.004% by mass, it is possible to suppress a reaction between Mg and P; and thereby, the effects of Mg can be reliably obtained.

Furthermore, in the first embodiment, the tensile strength is in a range of 750 MPa or more, and the electrical conductivity is in a range of 10% IACS or more. Therefore, when the copper alloy with high strength and high electrical conductivity according to the first embodiment is applied to connector terminals, lead frames, or the like, it is possible to decrease the thickness of the connector terminals, the lead frames, or the like.

### (Second embodiment)

A copper alloy with high strength and high electrical conductivity according to a second embodiment has a composition which includes: Mg: more than 1.0% by mass to less than 4% by mass, Sn: more than 0.1 % by mass to less than 5% by mass, Ni: more than 0.1% by mass to less than 7% by mass, either one or both of P and B: 0.001% by mass or more to 0.5% by mass or less, at least one or more selected from Fe, Co, Al, Ag, Mn, and Zn: 0.01 % by mass or more to 5% by mass or less with a remainder being Cu and inevitable impurities.
In addition, the mass ratio Mg/Sn of the content of Mg to the content of Sn is in a range of 0.4 or more, and the mass ratio Ni/Sn of the content of Ni to the content of Sn is in a range of 0.2 to 3.
The second embodiment is different from the first embodiment in that Ni is further included and the content of P is in a range of 0.001 % by mass or more to 0.5% by mass or less in the second embodiment.
Hereinafter, reasons why the contents of the above elements are limited in the above ranges will be described.

### (Mg)

Mg is an element having an effect of improving the strength without greatly degrading the electrical conductivity. In addition, Mg has an effect of increasing the recrystallization temperature. Here, in the case where the content of Mg is in a range of 1.0% by mass or less, the above-described effects cannot be obtained.
On the other hand, in the case where the content of Mg is in a range of 4.0% by mass or more, intermetallic compounds including Mg remain when a thermal treatment is carried out for homogenization and solution treatment. Thereby, sufficient homogenization and solution treatment cannot be carried out. As a result, there is a concern that cracking may occur in cold working or hot working after the thermal treatment.
From such reasons, the content of Mg is set to be in a range of more than 1.0% by mass to less than 4% by mass.
Furthermore, Mg is a reactive metal. Therefore, in the case where an excessive amount of Mg is added, there is a concern that Mg oxides generated by reactions with oxygen may be included during melting and casting. In order to suppress the including of the Mg oxides, the content of Mg is preferably set to be in a range of more than 1.0% by mass to less than 3% by mass.

### (Sn)

Sn is an element of being solid-solubilized in a matrix phase of copper; and thereby, Sn has an effect of improving the strength and increasing the recrystallization temperature. Here, in the case where the content of Sn is in a range of 0.1% by mass or less, the effects cannot be obtained.
On the other hand, in the case where the content of Sn is in a range of 5% by mass or more, the electrical conductivity is greatly decreased. In addition, intermetallic compounds containing Sn and having a low melting point are unevenly generated due to segregation of Sn. Therefore, the intermetallic compounds containing Sn and having a low melting point remain when a thermal treatment is carried out for homogenization and solution treatment. Thereby, sufficient homogenization and solution treatment cannot be carried out. As a result, there is a concern that cracking may occur in cold working or hot working after the thermal treatment. In addition, Sn is a relatively expensive element. Therefore, in the case in where Sn is added at a content of more than necessary, the manufacturing cost increase.
From such reasons, the content of Sn is set to be in range of more than 0.1% by mass to less than 5% by mass. Meanwhile, in order to reliably obtain the above-described effects, the content of Sn is preferably set to be in a range of more than 0.1% by mass to less than 2% by mass.

### (Ni)

Ni is an element having effects of improving the strength and increasing the recrystallization temperature when Ni is included together with Mg and Sn. In addition, Ni has an effect of increasing a melting point of intermetallic compounds that segregate in an ingot. Therefore, melting of the intermetallic compounds in a subsequent thermal treatment can be suppressed; and thereby, an effect of improving the workability is obtained. Here, in the case where the content of Ni is in a range of 0.1% by mass or less, the effects cannot be obtained.
On the other hand, in the case where the content of Ni is in a range of 7% by mass or more, the electrical conductivity becomes greatly degraded.
From such reasons, the content of Ni is set to be in a range of more than 0.1 % by mass to less than 7% by mass.

### (Mg/Sn)

In the case where both of Mg and Sn are included, precipitates of (Cu, Sn)₂Mg or Cu₄MgSn, which are compounds thereof, are distributed in the matrix phase of copper; and thereby, the strength can be improved due to precipitation hardening.
Here, in the case where the mass ratio Mg/Sn of the content of Mg to the content of Sn is in a range of less than 0.4, a large amount of Sn is included compared to the content of Mg. In this case, as described above, the intermetallic compounds having a low melting point are generated; and thereby, the workability is degraded.
Therefore, the mass ratio Mg/Sn of the content of Mg to the content of Sn is set to be in a range of 0.4 or more; and thereby, the workability is secured.
Meanwhile, in order to suppress the remaining of the intermetallic compounds containing Sn and having a low melting point so as to reliably secure the workability and to reliably obtain the effect of improving the strength due to Sn, the mass ratio Mg/Sn of the content of Mg to the content of Sn is preferably set to be in a range of 0.8 to 10.

### (Ni/Sn)

In the case where the mass ratio Ni/Sn of the content of Ni to the content of Sn is in a range of less than 0.2, a large amount of Sn is included compared to the content of Ni. In this case, as described above, intermetallic compounds having a low melting point become liable to be generated; and thereby, the workability is degraded.
In addition, in the case where the mass ratio Ni/Sn of the content of Ni to the content of Sn exceeds 3, the content of Ni increases; and thereby, the electrical conductivity greatly degrades.
Therefore, the mass ratio Ni/Sn of the content of Ni to the content of Sn is set to be in a range of 0.2 to 3; and thereby, the workability is secured while securing the electrical conductivity.

### (B, P)

B and P are elements that improve the strength and the heat resistance. In addition, P has an effect of lowering the viscosity of molten copper during melting and casting. Here, in the case where the contents of B and P are in a range of less than 0.001 % by mass, the effects cannot be obtained.
On the other hand, in the case where the contents of B and P exceed 0.5% by mass, the electrical conductivity greatly degrades.
From such reasons, the contents of either one or both of B and P are set to be in a range of 0.001% by mass or more to 0.5% by mass or less.

### (Fe, Co, Al, Ag, Mn, and Zn)

Fe, Co, Al, Ag, Mn, and Zn have an effect of improving the characteristics of a copper alloy, and it is possible to improve the characteristics by selectively including one or more of Fe, Co, Al, Ag, Mn, and Zn in accordance with use. Here, in the case where the content of at least one or more of elements selected from Fe, Co, Al, Ag, Mn, and Zn is in a range of less than 0.01 % by mass, the effects cannot be obtained.
On the other hand, in the case where the content of at least one or more of elements selected from Fe, Co, Al, Ag, Mn, and Zn exceeds 5% by mass, the electrical conductivity is greatly degraded.
From such reasons, the content of at least one or more of elements selected from Fe, Co, Al, Ag, Mn, and Zn is set to be in a range of 0.01% by mass to 5% by mass.

Meanwhile, the inevitable impurities include Ca, Sr, Ba, Sc, Y, rare earth elements, Zr, Hf, V, Nb, Ta, Cr, Mo, W, Re, Ru, Os, Se, Te, Rh, Ir, Pd, Pt, Au, Cd, Ga, In, Li, Si, Ge, As, Sb, Ti, Tl, Pb, Bi, S, O, C, Be, N, H, Hg, and the like. The inevitable impurities are preferably included at a total content of 0.3% by mass or less.

With regard to the copper alloy with high strength and high electrical conductivity according to the second embodiment having the above-described chemical components, Mg, Sn, and Ni are included, the content of Mg is set to be in a range of more than 1.0% by mass to less than 4% by mass, the content of Sn is set to be in a range of more than 0.1 % by mass to less than 5% by mass, and the content ofNi is set to be in a range of more than 0.1% by mass to less than 7% by mass. Therefore, by including all of Mg, Sn, and Ni it is possible to improve the strength due to solid solution hardening and precipitation hardening. In addition, the contents of Mg, Sn, and Ni are suppressed; and thereby, the workability and the electrical conductivity can be secured.

In addition, either one or both of P and B are included, and the contents are set to be in a range of 0.001 % by mass or more to 0.5% by mass or less. Therefore, it is possible to improve the strength and the heat resistance while suppressing degradation of the electrical conductivity.
Furthermore, at least one or more selected from Fe, Co, Al, Ag, Mn, and Zn are included, and the content is set to be in a range of 0.01% by mass or more to 5% by mass or less. Therefore, due to one or more elements selected from Fe, Co, Al, Ag, Mn, and Zn, it is possible to improve the characteristics of the copper alloy without greatly degrading the electrical conductivity.

Furthermore, in the second embodiment, the tensile strength is in a range of 750 MPa or more, and the electrical conductivity is in a range of 10% IACS or more. Therefore, when the copper alloy with high strength and high electrical conductivity according to the second embodiment is applied to connector terminals, lead frames, or the like, it is possible to decrease the thickness of the connector terminals, the lead frames, or the like.

### (Method of manufacturing the copper alloy with high strength and high electrical conductivity)

Next, a method for manufacturing the copper alloys with high strength and high electrical conductivity according to the first and second embodiments will be described.

### (Melting and casting process)

Firstly, copper raw materials are melted to obtain molten copper, and the above-described components are added to the obtained molten copper so as to conduct component adjustment. Thereby, a molten copper alloy is produced. Meanwhile, a single element, a master alloy, or the like can be used as the raw materials including the elements that are added. In addition, the raw materials including the elements may be melted together with the copper raw materials. In addition, recycled materials and scrap materials of the present alloy may also be used.
Here, the molten copper is preferably 4NCu having a purity of 99.99% or more. In addition, in the melting process, a vacuum furnace or an atmosphere furnace of which atmosphere is an inert gas atmosphere or a reduction atmosphere is preferably used in order to suppress oxidization of Mg and the like.
Then, the molten copper alloy of which the components are adjusted is casted into a mold so as to produce ingots. Meanwhile, in the case where mass production is taken into account, it is preferable to apply a continuous casting method or a semi-continuous casting method.

### (First thermal treatment process)

Next, a first thermal treatment process is carried out for homogenization and solution treatment of the obtained ingots. During the progress of solidification, the added elements segregate and concentrate; and thereby, intermetallic compounds and the like are generated. In the interior of the ingot, these intermetallic compounds and the like are present. Therefore, the ingots are subjected to the first thermal treatment; and thereby, the added elements are evenly dispersed, and the added elements are solid-solubilized in the matrix phase of the copper in the ingots. As a result, segregation of the intermetallic compounds and the like is eliminated or reduced, or the intermetallic compounds are eliminated or reduced.
Conditions for the thermal treatment in the first thermal treatment process are not particularly limited; however, it is preferable that the first thermal treatment is carried out at a temperature of 500°C to 800°C in a non-oxidation atmosphere or a reduction atmosphere.

In addition, hot working (hot processing) may be carried out after the above-described first thermal treatment in order to increase the efficiency of rough processing and the uniformity of the structure. The working method is not particularly limited; for example, rolling can be employed in the case where the final form is a sheet or a strip. Wire drawing, extrusion, groove rolling, and the like can be employed in the case where the final form is a line or a rod. In addition, forging or pressing can be employed in the case where the final form is a bulk shape. Meanwhile, the temperature of the hot working is also not particularly limited; however, it is preferable that the temperature of the hot working is set to be in a range of 500°C to 800°C.

### (Working process)

The heat-treated ingots are cut, and surface milling is carried out in order to remove oxidized films and the like that are generated by the thermal treatment and the like. Then, working (processing) is carried out in order to have a predetermined shape.
Here, a working method is not particularly limited; for example, rolling can be employed in the case where the final form is a sheet or a strip. Wire drawing, extrusion, groove rolling, and the like can be employed in the case where the final form is a line or a rod. In addition, forging or pressing can be employed in the case where the final form is a bulk shape. Meanwhile, the temperature conditions of the working are not particularly limited; however, the working is preferably cold working or warm working. In addition, the working rate is appropriately adjusted so as to have a shape approximate to the final shape; however, the working rate is preferably in a range of 20% or more.

Meanwhile, during the working process, a thermal treatment may be appropriately carried out in order to promote solution treatment, to obtain recrystallized structures, or to improve the workability. Conditions for the thermal treatment are not particularly limited; however, it is preferable that the thermal treatment is carried out at a temperature of 500°C to 800°C in a non-oxidation atmosphere or a reduction atmosphere.

### (Second thermal treatment process)

Next, the processed materials obtained through the working process is subjected to a second thermal treatment in order to carry out hardening due to low-temperature annealing and precipitation hardening, or to remove residual strains. Conditions of the second thermal treatment are appropriately set depending on characteristics that are required for products to be produced.
Meanwhile, the conditions of the second thermal treatment are not particularly limited; however, it is preferable that the second thermal treatment is carried out at a temperature of 150°C to 600°C for 10 seconds to 24 hours in a non-oxidation atmosphere or a reduction atmosphere. In addition, the working prior to the second thermal treatment and the second thermal treatment may be carried out a plurality of times.
In accordance with the above-described manner, the copper alloys with high strength and high electrical conductivity of the first and second embodiments are produced (manufactured).

The copper alloys with high strength and high electrical conductivity of the embodiments of the present invention are explained. The present invention is not limited thereto, and the embodiments can be appropriately modified within the scope of the technical features of the present invention.
For example, the first embodiment is explained that the copper alloy contains elements other than Mg and Sn; however, the present invention is not limited thereto, and elements other than Mg and Sn may be added according to necessity.
The second embodiment is explained that the copper alloy contains elements other than Mg, Sn, and Ni; however, the present invention is not limited thereto, and elements other than Mg, Sn, and Ni may be added according to necessity.
In addition, an example of the method for manufacturing the copper alloys with high strength and high electrical conductivity according to the first and second embodiments is explained; however, the manufacturing method is not limited to the embodiment, and existing manufacturing methods may be appropriately selected so as to manufacture the copper alloys.

### EXAMPLES

Hereinafter, the results of confirmation tests that were carried out to confirm the effects of the embodiments will be described.
A copper raw material composed of oxygen-free copper having a purity of 99.99% or more was prepared. The copper raw material was fed into a highly pure graphite crucible, and the copper raw material was melted using a high frequency heater in an atmosphere furnace having an Ar gas atmosphere. A variety of elements were added to the obtained molten copper so as to prepare the component compositions shown in Table 1. Next, molten copper alloys were casted into carbon casting molds so as to produce ingots. Meanwhile, the sizes of the ingot were set to a thickness of approximately 20 mm x a width of approximately 20 mm x a length of approximately 100 mm.

The obtained ingots were subjected to a thermal treatment (a first thermal treatment) at 715°C for 4 hours in an Ar gas atmosphere.
The heat-treated ingots were cut, and surface milling was carried out in order to remove oxidation films. Thereby, body blocks having a thickness of approximately 8 mm x a width of approximately 18 mm x a length of approximately 100 mm were produced.

The body blocks were subjected to cold rolling at a rolling reduction of approximately 92% to 94% so as to produce strips having a thickness of approximately 0.5 mm x a width of approximately 20 mm.
Each of the strips was subjected to a thermal treatment (a second thermal treatment) at a temperature as described in Table 1 for 1 hour to 4 hours in an Ar gas atmosphere so as to manufacture a strip for characteristics evaluation.

### (Workability Evaluation)

Presence or absence of cracked edges during the above-described cold rolling was observed to evaluate the workability. Copper alloys in which no or little cracked edges were visually observed were evaluated to be A (excellent), copper alloys in which small cracked edges having a length of less than 1 mm were caused were evaluated to be B (good), copper alloys in which cracked edges having a length of 1 mm to less than 3 mm were caused were evaluated to be C (fair), copper alloys in which large cracked edges having a length of 3 mm or more were caused were evaluated to be D (bad), and copper alloys which were broken due to cracked edges during the rolling were evaluated to be E (very bad).
Meanwhile, the length of the cracked edge refers to the length of the cracked edge from the end portion in the width direction toward the center portion in the width direction of the rolled material.

In addition, the tensile strengths and the electrical conductivities of the strips for characteristics evaluation were measured by the following method.

### (Tensile Strength)

Test specimens No. 13B defined by JIS Z 2201 were taken from the strips for characteristics evaluation, and the tensile strengths of the test specimens were measured at room temperature (25°C) according to the regulations of JIS Z 2241. Meanwhile, the test specimens were taken in a state in which the tensile direction in the tensile tests was in parallel with the rolling direction of the strips for characteristics evaluation.

### (Electrical Conductivity)

Test specimens having a width of 10 mm x a length of 60 mm were taken from the strips for characteristics evaluation, and electrical resistance was obtained by the four-terminal method. In addition, dimensions of the test specimens were measured using a micrometer, and volumes of the test specimens were calculated. Then, electrical conductivities were calculated from the measured electrical resistance values and the values of the volumes. Meanwhile, the test specimens were taken in a state in which the longitudinal direction of the test specimens was in parallel with the rolling direction of the strips for characteristics evaluation.
The evaluation results are shown in Tables 1 to 3.

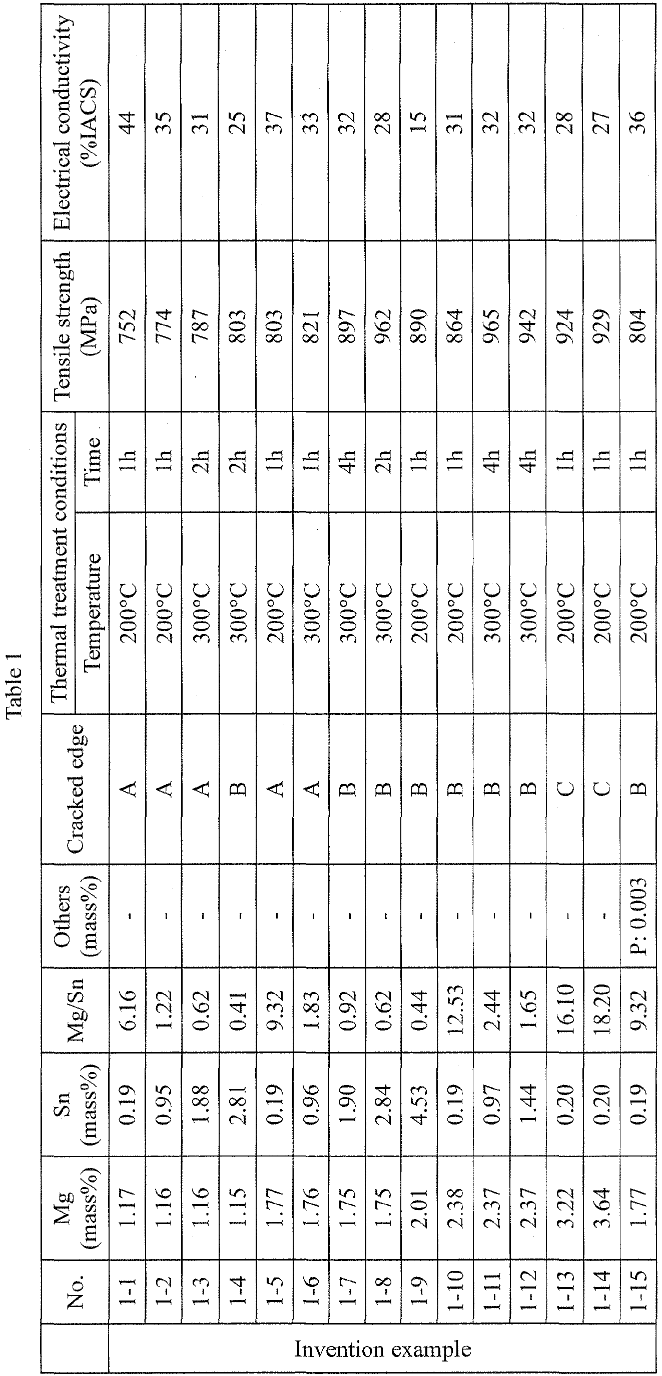

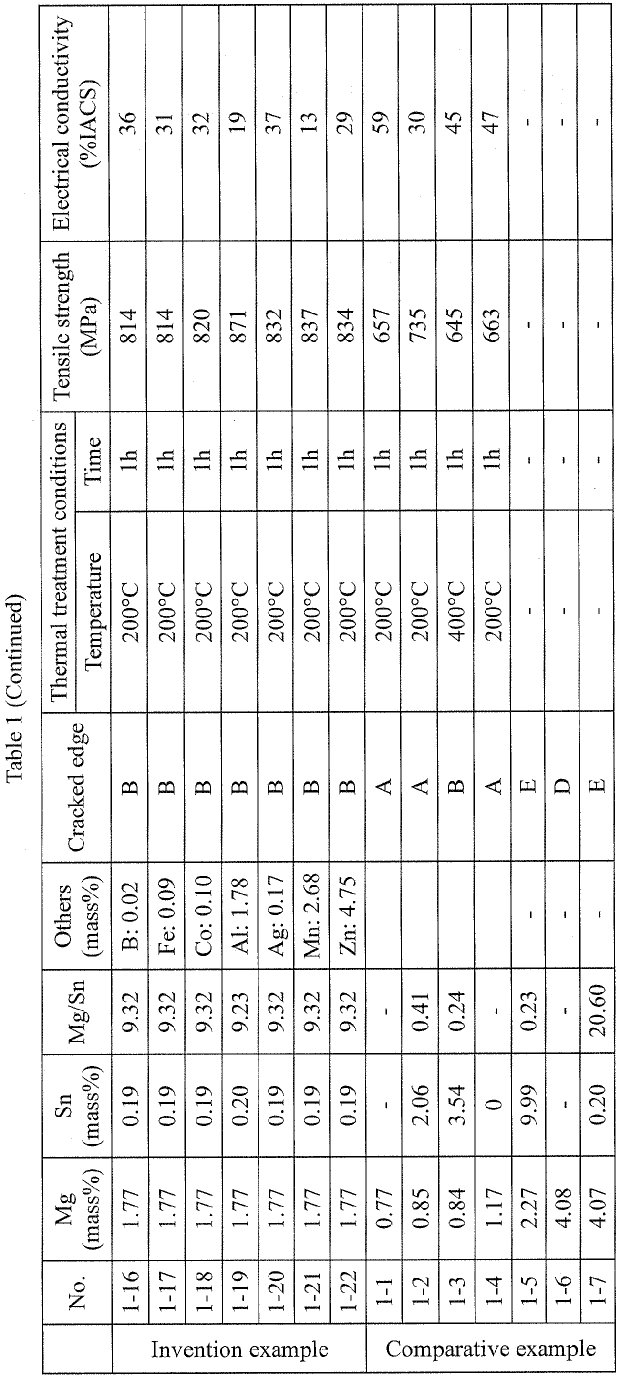

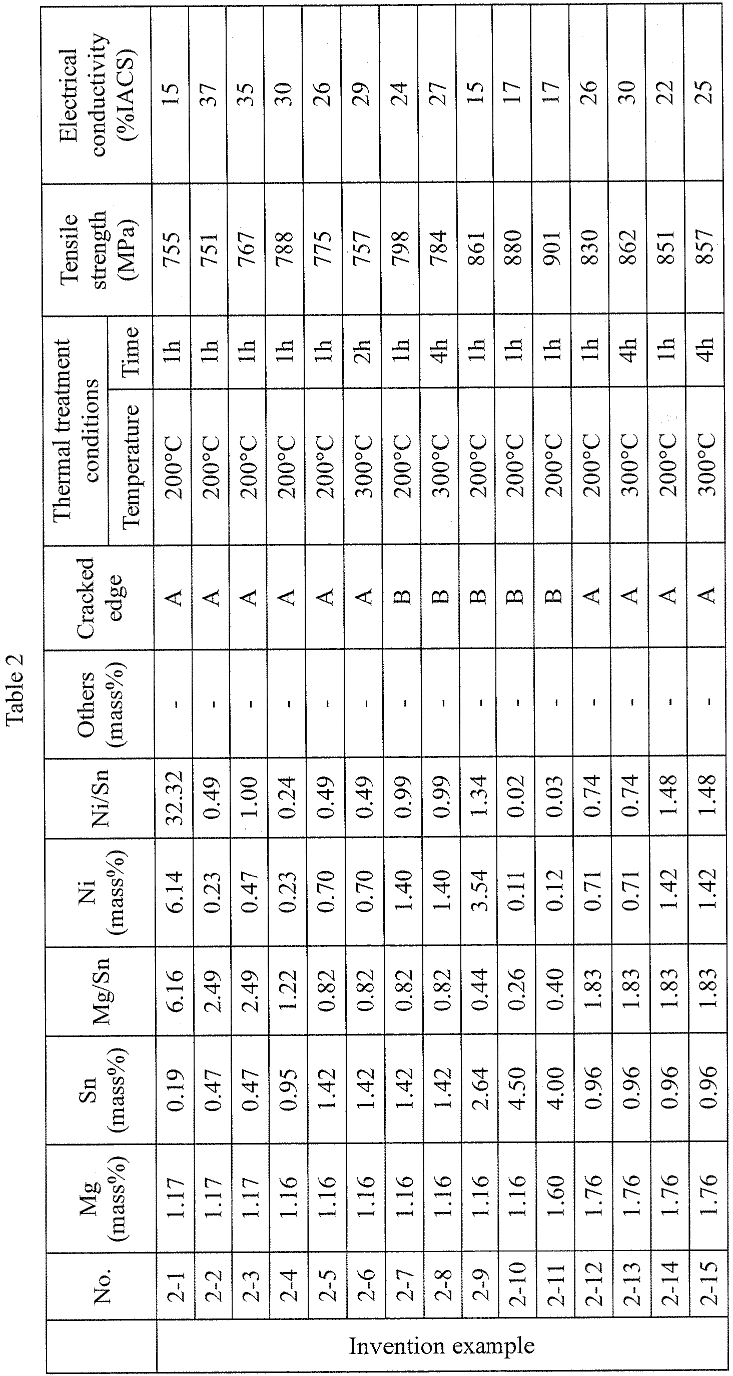

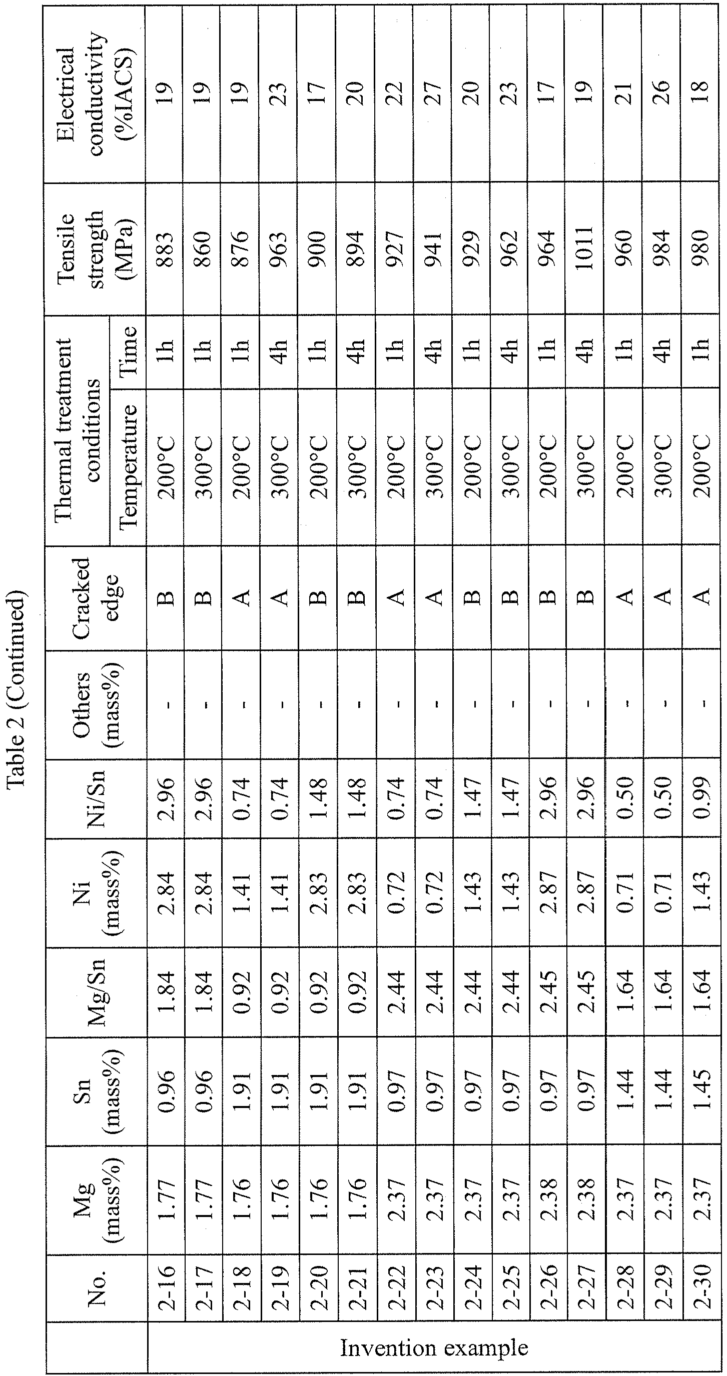

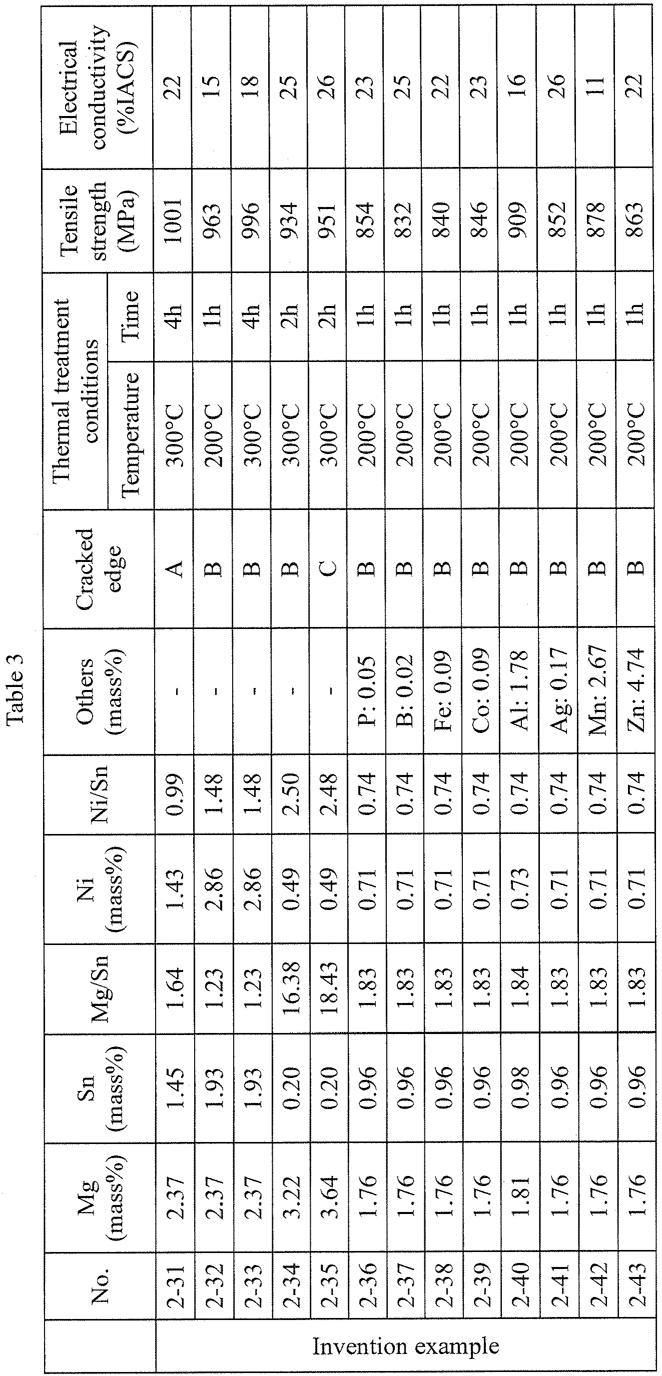

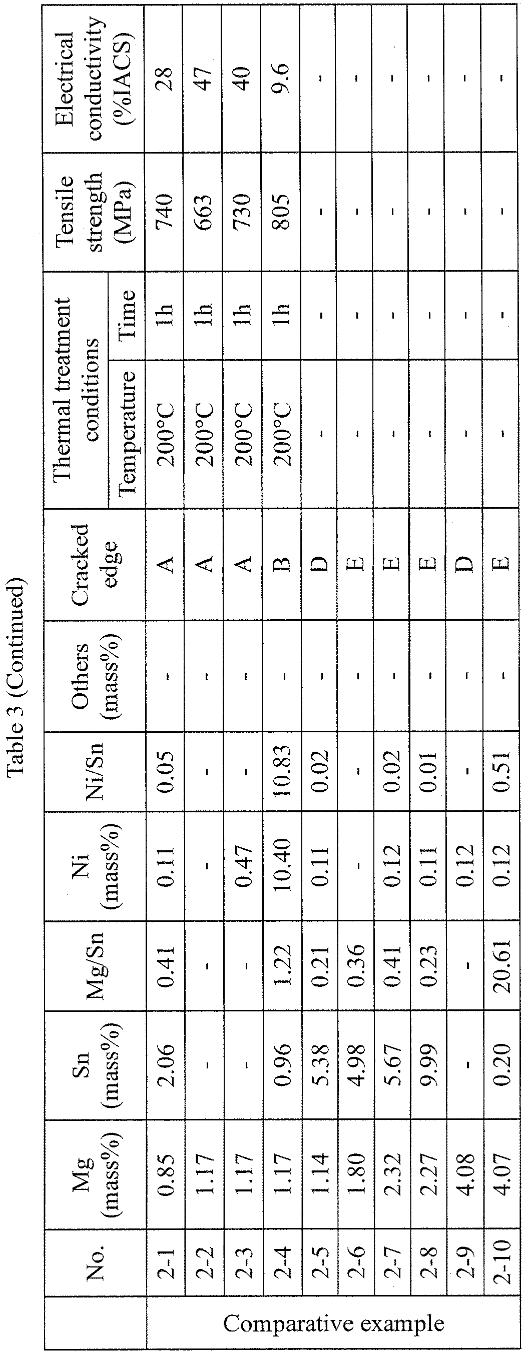

In Comparative example 1-1, only Mg was included, and the content of Mg was less than 1% by mass. The tensile strength was 657 MPa which was low.
In Comparative example 1-2, Mg and Sn were included, and the content of Mg was less than 1% by mass. The tensile strength was 735 MPa.
In Comparative example 1-3, Mg and Sn were included, the content of Mg was less than 1% by mass, and the mass ratio Mg/Sn of the content of Mg to the content of Sn was less than 0.4. The tensile strength was 645 MPa.
In Comparative example 1-4, only Mg was included, and the content of Mg was 1% by mass or more. The tensile strength was 663 MPa which was low.

In Comparative example 1-5, Mg and Sn were included, the content of Sn was 5% by mass or more, and the mass ratio Mg/Sn of the content of Mg to the content of Sn was less than 0.4. Cracked edges were drastically caused, and the copper alloy was broken during the rolling.
In Comparative example 1-6, only Mg was included, and the content of Mg was 4% by mass or more. Large cracked edges having a length of 3 mm or more were caused.
In Comparative example 1-7, Mg and Sn were included, and the content of Mg was 4% by mass or more. Cracked edges were drastically caused, and the copper alloy was broken during the rolling.

In Comparative example 2-1, the content of Mg was 1.0% by mass or less. In Comparative example 2-2, Sn and Ni were not included. In Comparative example 2-3, Sn was not included. The tensile strengths in all of Comparative examples 2-1, 2-2, and 2-3 were less than 750 MPa.
In Comparative example 2-4, the content of Ni was 7% by mass or more, and the electrical conductivity was 9.6% IACS which was low.

In Comparative examples 2-5, 2-7, and 2-8, the contents of Sn were 5% by mass or more, and large cracked edges were caused during the cold rolling. In Comparative examples 2-7 and 2-8, the copper alloys were broken during the rolling.
In Comparative example 2-6, Ni was not included, large cracked edges were caused during the cold rolling, and the copper alloy was broken during the rolling.
In Comparative examples 2-9 and 2-10, the contents of Mg were 4% by mass or more, and large cracked edges were caused during the cold rolling. In Comparative example 2-10, the copper alloy was broken during the rolling.

In contrast to the above-described results, in Examples 1-1 to 1-22 and Examples 2-1 to 2-43, it was confirmed that the tensile strengths were 750 MPa or more, and the electrical conductivities were 10% or more. In addition, no cracked edges having a size of 3 mm or more were confirmed during the hot rolling.
From the above-described results, it was confirmed that according to the present invention, a copper alloy with high strength and high electrical conductivity can be produced without working troubles caused by cracked edges and the like, and the copper alloy has the tensile strength of 750 MPa, and the electrical conductivity of 10% or more.

### INDUSTRIAL APPLICABILITY

According to the present invention, it is possible to provide a copper alloy with high strength and high electrical conductivity which requires low raw material cost and manufacturing cost and which is excellent in tensile strength, electrical conductivity, and workability. The copper alloy with high strength and high electrical conductivity can be suitably applied to electronic and electrical parts, such as connector terminals, lead frames, and the like that are used in electronic devices, electrical devices, and the like.

## Claims

1. A copper alloy with high strength and high electrical conductivity, comprising:
Mg: more than 1.0% by mass to less than 4% by mass; and
Sn: more than 0.1 % by mass to less than 5% by mass,
with a remainder including Cu and inevitable impurities,
wherein a mass ratio Mg/Sn of a content of Mg to a content of Sn is in a range of 0.4 or more.

2. The copper alloy with high strength and high electrical conductivity according to Claim 1,
wherein the mass ratio Mg/Sn of the content of Mg to the content of Sn is in a range of 0.8 to 10.

3. The copper alloy with high strength and high electrical conductivity according to Claim 1,
wherein the copper alloy further comprises at least one or more selected from Fe, Co, Al, Ag, Mn, and Zn, and a content thereof is in a range of 0.01 % by mass or more to 5% by mass or less.

4. The copper alloy with high strength and high electrical conductivity according to Claim 1,
wherein the copper alloy further comprises B: 0.001% by mass or more to 0.5% by mass or less.

5. The copper alloy with high strength and high electrical conductivity according to Claim 1,
wherein the copper alloy further comprises P: less than 0.004% by mass.

6. The copper alloy with high strength and high electrical conductivity according to Claim 1,
wherein a tensile strength is in a range of 750 MPa or more, and an electrical conductivity is in a range of 10% IACS or more.

7. The copper alloy with high strength and high electrical conductivity according to Claim 1,
wherein the copper alloy further comprises Ni: more than 0.1% by mass to less than 7% by mass.

8. The copper alloy with high strength and high electrical conductivity according to Claim 7,
wherein a mass ratio Ni/Sn of a content of Ni to a content of Sn is in a range of 0.2 to 3.

9. The copper alloy with high strength and high electrical conductivity according to Claim 7,
wherein the copper alloy further comprises either one or both of P and B, and a content thereof is in a range of 0.001 % by mass or more to 0.5% by mass or less.

10. The copper alloy with high strength and high electrical conductivity according to Claim 7,
wherein the copper alloy further comprises at least one or more selected from Fe, Co, Al, Ag, Mn, and Zn, and a content thereof is in a range of 0.01 % by mass or more to 5% by mass or less.

11. The copper alloy with high strength and high electrical conductivity according to Claim 7,
wherein a tensile strength is in a range of 750 MPa or more, and an electrical conductivity is in a range of 10% IACS or more.
